# FASCICULE DE BREVET EUROPEEN

(11) **EP 1 102 412 B1**
(45) Date de publication et mention de la délivrance du brevet: **10.04.2002**
(21) Numéro de dépôt: 00403083.9
(22) Date de dépôt: 07.11.2000
(51) Int. Cl.: H04B 1/38, H04B 15/04, H05K 9/00

(54) **Téléphone mobile extra plat**
Flaches mobiltelefon
Flat mobile telephone

(30) Priorité: 19.11.1999 FR 9914612
(43) Date de publication de la demande: 23.05.2001
(73) Titulaire: SAGEM S.A., 75015 Paris (FR)
(72) Inventeur: Heurtaux, Frédéric, 13610 Le Puys Ste Reparade (FR); Delacourte, Bruno, 95290 L'Isle Adam (FR)
(74) Mandataire: Schmit, Christian Norbert Marie

(56) Documents cités:
- US-A- 5 422 751
- US-A- 5 596 487
- US-A- 5 805 251

## Description

La présente invention à pour objet un téléphone mobile extra plat. Le domaine de l'invention est le domaine de la téléphonie mobile. Le but de l'invention est de réduire l'encombrement, notamment l'épaisseur, d'un téléphone mobile. Le domaine de l'invention peut donc aussi s'étendre à d'autres appareils électroniques présentant les même caractéristiques qu'un téléphone mobile, et dont on souhaite diminuer l'encombrement.

L'autre but de l'invention est de réduire les coûts des téléphones mobiles, en effet si le téléphone mobile est moins encombrant il nécessite moins de matière pour le réaliser.

Actuellement les téléphones mobiles sont devenus des outils de travail courant, et font partie des objets que l'on emporte partout avec soi. Les téléphones mobiles doivent donc pouvoir se glisser dans un sac ou dans une poche sans difficulté. Il est donc important que leur encombrement soit réduit au maximum, sans pour autant que cette réduction nuise à leur ergonomie.

Il faut en effet que l'on soit toujours capable de manipuler le téléphone mobile, sans être obligé d'avoir recours à des pincettes. Il n'est donc pas possible de réduire indéfiniment la hauteur et la largeur d'un téléphone mobile. En effet le nombre d'informations affichées sur l'écran va croissant, il faut donc des écrans de plus en plus grands. Les touches du clavier doivent avoir une taille et un espacement minimal afin que le clavier soit utilisable. L'écran et le clavier doivent donc conserver des dimensions raisonnables afin que l'utilisation du téléphone mobile reste simple et conviviale.

Dans l'état de la technique un téléphone mobile comporte des circuits radioélectriques, une antenne et un écran entre autre. Afin de limiter les pertes en transmission et les rayonnements électromagnétiques non désirés, les circuits radioélectriques sont situés à proximité de l'antenne qui est elle-même située en haut du téléphone. Ainsi entre les circuits radioélectriques qui les produisent et l'antenne qui les diffuse les signaux radioélectriques n'ont que peu de chemin à parcourir. Cette mise en oeuvre conduit à placer les circuits radioélectriques en dessous de l'écran du téléphone mobile. L'écran est en effet lui-même situé en haut du téléphone mobile.

Parmi les circuits radioélectriques on trouve des circuits intégrés, des oscillateurs et différents autres composants électronique dont l'encombrement, notamment la hauteur ne peut pas être réduite au-delà d'un certain seuil. De plus ces composants émettent un rayonnement électromagnétique qui va au-delà des normes électromagnétiques en vigueur. Il est donc nécessaire de les entourer d'un blindage. Un blindage est une cage métallique, aussi appelé cage de Faraday, qui entoure les composants pour lesquels on veut empêcher qu'ils émettent des rayonnements électromagnétiques dans l'atmosphère, ou pour lesquels on veut empêcher qu'ils soient perturbés par des rayonnements électromagnétiques venant de l'atmosphère. Cette cage doit donc être métallique et avoir une structure rigide pour ne pas provoquer de courts circuits avec les différents composants qu'elle entoure.

L'écran est donc situé au-dessus du blindage. L'écran est en général constitué par un afficheur à cristaux liquides et une vitre de protection travers laquelle l'utilisateur du téléphone mobile peut lire ce qui est affiché sur l'afficheur à cristaux liquides. Dans la plupart des cas il existe, entre le blindage et l'afficheur à cristaux liquides, un dispositif de rétro-éclairage. Ce dispositif sert à éclairer l'afficheur à cristaux liquides lorsque le téléphone mobile est utilisé dans une ambiance lumineuse faible. Le dispositif de rétro-éclairage comporte la plupart du temps un guide de lumière qui permet d'assurer une bonne diffusion de la lumière sur toute la surface de l'écran. Ce guide de lumière a lui aussi une épaisseur qui n'est pas réductible au-delà d'un certain seuil.

L'épaisseur d'un téléphone mobile de l'état de la technique est donc conditionnée par la hauteur des composants électroniques radioélectriques, l'épaisseur du blindage, l'épaisseur du dispositif de rétro-éclairage et l'épaisseur de l'écran. Dans la pratique il arrive que l'on utilise pour le dispositif de rétro-éclairage un film électroluminescent. Cependant celui-ci, si son épaisseur est faible, présente le défaut d'être fortement rayonnant. Avec le durcissement des normes électromagnétiques cette solution n'est plus envisageable.

L'invention résout ces problèmes en cumulant sur un même dispositif plusieurs fonctions. Les fonctions cumulées sont celles de blindage et d'écran. On utilise la face arrière de l'écran, qui peut être la face arrière du guide de lumière associé à l'écran, comme couvercle du dispositif de blindage. Pour se faire on métallise cette face arrière. Puis on réalise des raccords jusqu'au circuit imprimé sur lequel sont implantés les composants rayonnants grâce à un cadre conducteur lui aussi. Les jonctions entre la face arrière métallisé et le cadre métallique, et entre une ligne de masse du circuit imprimé et le cadre métallique sont assurées grâce à un joint conducteur. On obtient ainsi une réduction significative de l'épaisseur du téléphone.

Le téléphone mobile comporte aussi un clavier qui a lui aussi besoin d'être rétro-éclairé. Sous le clavier se trouve donc un guide de lumière visant à diffuser la lumière pour le rétro éclairage, ainsi qu'un circuit imprimé pour conduire les signaux délivrés par le clavier. On réduit l'épaisseur des téléphones mobiles à la verticale du clavier en supprimant le circuit imprimé et en le réalisant par une métallisation sélective du guide de lumière. On cumule ainsi deux fonctions sur le guide de lumière, celle de circuit imprimé et de guide de lumière.

L'invention à donc pour objet un téléphone mobile comportant un écran et des composants électroniques rayonnants fixés sur un circuit imprimé et isolés par un dispositif de blindage caractérisé en ce que le dispositif de blindage est intégré à un élément de l'écran sous forme d'une métallisation de la face arrière de cet élément de l'écran, le dispositif de blindage est alors constitué par la face arrière métallisée de l'écran et un cadre conducteur qui assure la liaison électrique entre la face arrière métallisée et une masse du circuit imprimé, les composants rayonnant sont alors situés sous l'écran et à l'intérieur du cadre.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1a : la représentation d'un téléphone mobile selon l'invention sans dispositif de rétro-éclairage ;
- Figure 1b: la vue de la figure en coupe et de dessus 1 a ;
- Figure 2 : une représentation d'un téléphone mobile selon l'invention avec un dispositif de rétro-éclairage sous la forme d'un film électroluminescent ;
- Figure 3 : une représentation d'un téléphone mobile selon l'invention avec un dispositif de rétro-éclairage comportant un guide de lumière ;
- Figure 4 : une représentation d'un téléphone mobile selon l'invention avec un guide de lumière commun pour l'écran et le clavier.

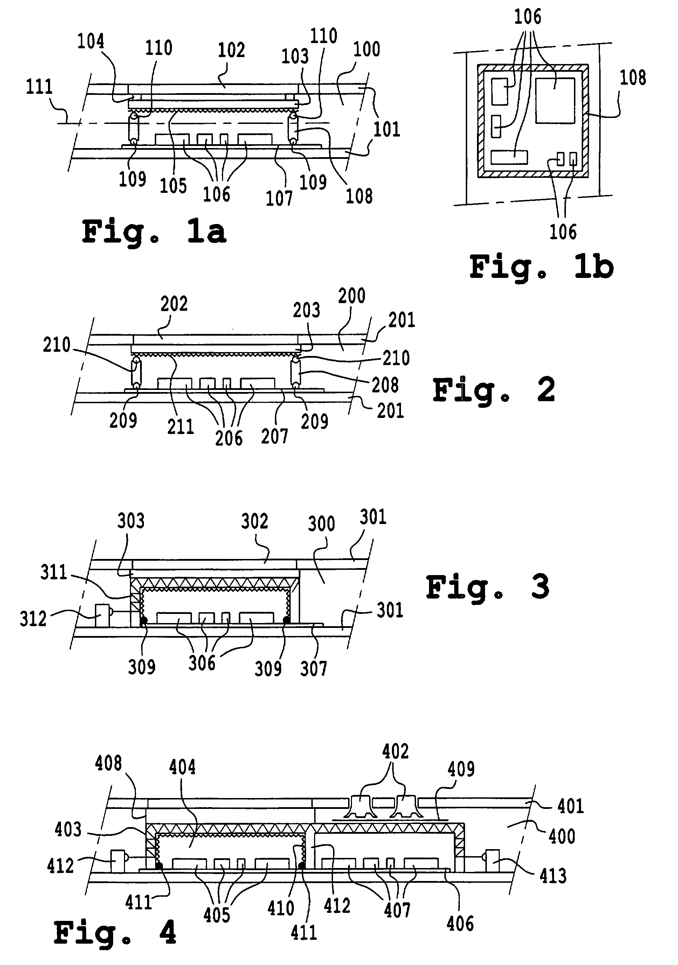

La figure 1a montre un téléphone 100 mobile en coupe longitudinale selon son épaisseur. La figure 1a montre la coque 101 du téléphone mobile 100, la partie supérieure de la coque comporte une vitre 102. La vitre 102 est réalisée dans un matériel transparent et permet à l'utilisateur du téléphone 100 de voir des éléments d'image qui sont affichés sur un écran 103 à cristaux liquides du téléphone 100. Selon les modes de réalisation du téléphone 100, il peut exister un joint 104 qui assure le contact entre l'écran 103 et la vitre 102. Cependant il existe des écrans à cristaux liquides qui incorporent les vitres de protections. Dès lors le joint 104 n'est plus nécessaire. On utilisera avantageusement, dans l'invention, des écrans qui incorporent des vitres de protections car ils conduisent à des réalisations de moindres épaisseurs.

On distingue pour l'écran 103 une face avant et une face arrière. La face avant est celle que rencontre en premier le regard de l'utilisateur lorsqu'il regarde l'écran monté dans le téléphone 100 en état de marche, la face arrière est donc celle qui est opposée à la face avant. La figure 1 a montre que la face arrière de l'écran 103 comporte une métallisation 105.

La figure 1a montre aussi des composants 106 électroniques rayonnants. Ces composants sont implantés sur un circuit imprimé 107. Le circuit imprimé 107 comporte aussi une ligne de masse qui fait le tour des composants 106 rayonnants. Sur cette ligne de masse on positionne un cadre 108 conducteur. Le cadre 108 peut être métallique ou simplement avoir ses faces intérieures métallisées. Les faces intérieures du cadre 108 sont celles qui sont le plus proche des composants 106. Le cadre 108 a une hauteur suffisante pour recouvrir les composants 106. C'est-à-dire que la hauteur du cadre 106 est au moins égale à la hauteur du composant le plus haut parmi ceux qui sont implantés à l'intérieur du cadre 108. Le contact entre le cadre 108 et la piste de masse du circuit imprimé 107 est réalisé grâce à un joint 109 conducteur. Cela permet d'assurer la continuité électrique entre la piste de masse et le cadre 108. Dans une variante de l'invention, le contact entre le cadre 108 et la piste de masse est réalisé grâce à des picots implantés sur le circuit 107. On enfiche le cadre 108 sur ces picots. Ces picots sont conducteurs et assurent que le cadre est à un potentiel de masse.

D'autre part le cadre 108 est au contact avec la face métallisée de l'écran 103 par l'intermédiaire d'un deuxième joint conducteur 110. On réalise ainsi l'isolation électromagnétique des composants 106 rayonnant. Il est entendu que le potentiel de masse est aussi repris en dessous des composants 106 par l'intermédiaire d'un plan de masse qui est, par exemple, une métallisation du circuit imprimé 107. Cette métallisation de masse se fait sur une face opposée à celle sur laquelle sont implantés les composants 106. Dans le cas d'un circuit multicouche, cette face opposée est l'une de celle sur laquelle ne sont pas implantés les composants 106.

Selon l'exemple de la figure 1a les composants 106 rayonnants occupent toute la surface qui se trouve sous l'écran 103. Dans la pratique il peut en être autrement, notamment à cause de l'intégration croissante des composants. Dans ce cas la métallisation de la face arrière de l'écran 103 peut n'être que partielle. Dans ce cas toujours, les dimensions du cadre 108 seront réduites d'autant que nécessaire pour encadrer au plus près la surface occupée par les composants 106. Il en va de même pour la piste de masse du circuit 107. Cette piste de masse a le même contour que le cadre 108. Cet encadrement au plus près est réalisé dans un souci d'économiser de la place soit pour permettre d'implanter d'autres fonctions, soit pour réaliser une économie dans la réalisation.

La figure 1b est une vue de dessus et en coupe de la figure 1a selon un plan parallèle au circuit 107 et à mi-hauteur du cadre 108. Un plan de coupe est matérialisé par la ligne 111.

La figure 1b montre les composants 106 encadrés par le cadre 108. Dans l'exemple de la figure 1b le cadre est carré. Mais sa forme peut varier en fonction de l'implantation géographique des composants 106 sur le circuit 107. Dans la pratique le cadre 108 passe au plus près des composants 106 en respectant les contraintes électromagnétiques liées à l'emploi de ces composants 106.

Dans la pratique l'écran 103 et la vitre 102 sont maintenues en place par des moulages de la partie supérieure de la coque 101 du téléphone 100. Ces moulages ne sont pas représentés sur la figure 1 a, ni sur les suivantes, dans un souci de clarté.

La figure 2 montre un téléphone 200 comportant des éléments 201 à 210 identiques aux éléments 101 a 110 du téléphone 100. Les références 204 et 205 ne sont pas utilisées. La figure 2 montre un film 211 électroluminescent dont l'une des faces, la face arrière, est métallisée. La face non métallisée du film 211 est collée sur la face arrière de l'écran 203. Le film 211 est donc situé entre l'écran 203 et le sommet du cadre 208.

Le film 211 permet donc de rétro-éclairer l'écran 203 lorsque le téléphone 200 est utilisé dans une ambiance lumineuse faible. Le fait que la face arrière du film 211 soit métallisée assure que l'ensemble formé par cette face arrière, le joint 210, le cadre 208 et le joint 209 forme bien une enveloppe conductrice étanche aux rayonnements électromagnétiques émis par les composants 206.

Le film électroluminescent 211 peut très bien être remplacé par un guide de lumière. Dans ce cas la face arrière du guide de lumière est métallisée et permet d'assurer l'isolation des composants 206.

L'intérêt des solutions décrites par les figures 1a et 2 réside dans la suppression d'un couvercle du cadre 108. En effet dans l'état de la technique, pour assurer une bonne isolation des composants 106, le cadre 108 est doté d'un couvercle ayant une épaisseur et sur lequel on venait placer l'écran 103 puis la vitre 102. Dans les réalisations décrites on économise donc l'épaisseur de ce couvercle.

La figure 3 montre un téléphone 300 comportant des éléments 301à 309 identiques aux éléments 101à 109 du téléphone 100. Les références 304, 305, 308 et 310 ne sont pas utilisées.

La figure 3 montre que le téléphone 300 comporte un couvercle 311 dont les bords ont une géométrie identique à celle du cadre 108. Ainsi lorsque le couvercle 311 est en place il couvre les composants 306 rayonnants. La hauteur entre les bords et le fond du couvercle 311 est suffisante pour que l'on puisse y loger le plus haut des composants 306 sans qu'il y ait de contact entre le fond du couvercle 311 et le composant le plus haut. Le couvercle 311 est réalisé dans un matériel conduisant la lumière. Le couvercle 311 est un guide lumière. La face interne du couvercle 311, c'est à dire celle qui est tournée vers les composants 306, et métallisée sur toute sa surface. Au contact entre la métallisation du couvercle 311 et du circuit 307 imprimé le téléphone 300 comporte un joint 309 conducteur. Le joint 309 assure la continuité électrique entre la métallisation du couvercle 311 et une piste de masse qui entoure les composants 306. La piste de masse est réalisée sur le circuit 307. Cette piste de masse suit, sur le circuit 307, le même contour que 311. Le circuit 307 comporte sur une face opposée au composant 306 un plan de masse qui couvre la surface ou sont implantés les composants 306. Ce plan de masse est au même potentiel que la ligne de masse avec laquelle est en contact le joint 309. On assure ainsi l'isolation électromagnétique des composants 306.

Dans une variante de l'invention, le contact entre le couvercle 311 et la piste de masse est assuré par des picots du circuit 307. Le couvercle 311 s'enfiche alors sur ces picots qui sont conducteur et à un potentiel de masse.

La partie du couvercle 311 qui est au contact avec l'écran 303 est généralement plane. Cependant elle peut comporter des excroissances pour assurer le positionnement et le maintient de l'écran 303.

La figure 3 montre aussi que le téléphone 300 comporte une source 312 de lumière. Cette source 312 de lumière est située à proximité du couvercle 311 qu'elle éclaire. De part ses propriétés optiques le couvercle 311 capte la lumière émise par la source 312 et la diffuse à travers sa structure. La figure 3 montre qu'un écran 303 est posé sur le dessus du couvercle 311. Lorsque la source 312 émet de la lumière, le couvercle 311 éclaire donc l'écran 303. Le couvercle 311 assure donc le rôle du guide de lumière pour le rétro-éclairage de l'écran 303, et aussi le rôle de blindage pour les composants 306 rayonnants.

L'écran 303 est maintenu en place d'une part par le couvercle 311, d'autre part par des excroissances de la coque 301 du téléphone 300. La coque 301 maintient aussi une vitre 302 à travers laquelle un utilisateur du téléphone 300 voit l'écran 303.

La figure 4 montre un téléphone 400 dont la partie supérieure d'une coque 401 est percée d'orifice afin de permettre à l'utilisateur du téléphone 400 d'accéder à un clavier 402. Le téléphone 400 comporte aussi un guide de lumière 403. Le guide de lumière 403 est réalisé comme le guide 311 décrit à la figure 3. Cependant le couvercle 403 comporte plusieurs compartiments. Le couvercle 403 comporte un premier compartiment 404 qui recouvre des composants 405 rayonnant. Les composants 405 sont implantés sur un circuit 406 imprimé. Le circuit 406 comporte d'autres composant 407 qui eux ne sont pas rayonnant. Au-dessus du guide de lumière 403 se trouve un écran 408 à cristaux liquides l'écran 408 est situé à coté du clavier 402. Le clavier 402 est lui aussi situé au-dessus du guide 403. Sous le clavier 402 et sur la partie supérieure du couvercle 403 se trouve des pistes métalliques constituant un circuit imprimé nécessaire au fonctionnement du clavier 402. Par cette réalisation on économise ainsi un circuit imprimé qui aurait du, dans l'état de la technique, se trouver entre le clavier 402 et le couvercle 403. Si pour son fonctionnement le clavier 402 nécessite un circuit imprimé à deux couches, l'une des couches est réalisée sur le dessus du couvercle 403, l'autre couche est réalisée sur la face arrière du clavier 402. Les deux faces sont alors isolées par un film 409 isolant. Les parois internes du compartiment 404 sont recouvertes par une métallisation 410. Le contact entre la métallisation 410 et une piste de masse du circuit 406 est assuré grâce à un joint conducteur 411. Le circuit 406 comporte aussi un plan de masse comme précédemment décrit afin de compléter le blindage.

Le téléphone 400 comporte aussi des sources 412 et 413 de lumière. Ces sources 412 et 413 sont situées à proximité du guide 403. Lorsqu'elles émettent de la lumière, cette lumière est captée par le guide 303 et diffusé par sa structure. Le guide 403 sert donc à rétro-éclairer l'écran 408 à cristaux liquides et le clavier 402. Mais le guide 403 sert aussi de blindage pour les composants 405 rayonnant, et de circuit imprimé pour le fonctionnement du clavier 402. Dans cette réalisation on économise donc l'emploi d'un dispositif de blindage spécifique pour les composants 405 et l'emploi d'un circuit imprimé spécifique pour le fonctionnement du clavier 402.

Les compartiments du couvercle 403 sont réalisés grâce à une cloison 412. Dans la mesure où seul le compartiment 404 a besoin d'être étanche au rayonnement magnétique, il n'est pas nécessaire que les bords du couvercle, ou cloison, ne correspondant pas au compartiment 404 soient pleins. Pour économiser de la matière ces bords peuvent être crénelés.

## Revendications

1. Téléphone (100) mobile comportant un écran (103) et des composants (106) électroniques rayonnants électromagnétiques fixés sur un circuit (107) imprimé et isolés par un dispositif de blindage **caractérisé en ce que** le dispositif (105) de blindage est intégré à un élément (103) de l'écran sous forme d'une métallisation (105) de la face arrière de cet élément de l'écran, le dispositif de blindage est alors constitué par la face arrière métallisée de l'écran et un cadre (108) conducteur qui assure la liaison électrique entre la face arrière métallisée et une masse du circuit imprimé, les composants rayonnants sont alors situés sous l'écran et à l'intérieur du cadre.

2. Téléphone selon la revendication 1, **caractérisé en ce que** la liaison électrique entre la face arrière de l'écran et le cadre, ainsi que la liaison électrique entre le cadre et le circuit imprimé sont assurées par des joints (110, 109) conducteurs.

3. Téléphone selon l'une des revendications 1 ou 2, **caractérisé en ce que** la liaison électrique entre la face arrière de l'écran et le cadre, ainsi que la liaison électrique entre le cadre et le circuit imprimé sont assurées par des picots conducteurs.

4. Téléphone selon l'une des revendications 1 à 3, **caractérisé en ce que** l'écran comporte un dispositif (211) d'éclairage constitué par un film électroluminescent dont l'une des faces est métallisée et fait office de face arrière de l'écran.

5. Téléphone selon l'une des revendications 1 à 4, **caractérisé en ce que** l'écran comporte un guide (311, 403) de lumière, la face arrière de ce guide de lumière étant métallisé pour participer au dispositif de blindage comme face arrière de l'écran.

6. Téléphone selon la revendication 5, **caractérisé en ce que** le guide de lumière est un couvercle (311, 403) couvrant les composants rayonnants, le couvercle est fabriqué dans un matériel conduisant la lumière, les bords du couvercle sont au contact du circuit imprimé via un joint conducteur, la face interne du couvercle est métallisée.

7. Téléphone selon l'une des revendications 5 ou 6, **caractérisé en ce que** le guide de lumière est un couvercle (311, 403) couvrant les composants rayonnants, le couvercle est fabriqué dans un matériel conduisant la lumière, les bords du couvercle sont au contact du circuit imprimé via des picots conducteurs, la face interne du couvercle est métallisée.

8. Téléphone selon l'une des revendications 5 à 7, **caractérisé en ce que** le guide de lumière sert aussi de guide de lumière pour un clavier (402) du téléphone, le guide de lumière comporte alors en vis à vis du clavier des métallisations sélectives, ou pistes, pour assurer le fonctionnement électrique du clavier, le guide de lumière comporte des parois dont certaines sont métallisées pour assurer le blindage des composants rayonnants.

9. Téléphone selon la revendication 8, **caractérisé en ce que** le clavier nécessite un circuit imprimé multicouche, une couche est réalisée sur le guide de lumière, l'autre couche est réalisée sur un cloqué (402) comportant des touches du clavier, l'isolation entre le cloqué et le guide de lumière étant alors réalisée grâce à un film isolant.

## Patentansprüche

1. Mobiltelephon (100) mit einem Schirm (103) und elektronischen, durch eine Abschirmungsvorrichtung elektromagnetisch abgeschirmten Abstrahlungskomponenten (106) auf einem gedruckten Schaltkreis (107), **dadurch gekennzeichnet, dass** die Abschirmungsvorrichtung (105) in einem Schirmelement (103) in Form einer Metallisierung (105) auf der Rückseite dieses Schirmelements integriert ist, wobei die Abschirmungsvorrichtung durch die metallisierte Rückseite des Schirms und einen leitfähigen Rahmen (108) gebildet wird, der die elektrische Verbindung zwischen der metallisierten Rückseite und einer Masse des gedruckten Schaltkreises sicherstellt, wobei die Abstrahlungskomponenten unter dem Schirm innerhalb des Rahmens angeordnet sind.

2. Telephon nach Anspruch 1, **dadurch gekennzeichnet, dass** die elektrische Verbindung zwischen der Rückseite des Schirms und dem Rahmen sowie die elektrische Verbindung zwischen dem Rahmen und dem gedruckten Schaltkreis durch leitfähige Verbindungsstellen (110, 109) sichergestellt wird.

3. Telephon nach Anspruch 1 oder 2, **dadurch gekennzeichnet, dass** die elektrische Verbindung zwischen der Rückseite des Schirms und dem Rahmen sowie die elektrische Verbindung zwischen dem Rahmen und dem gedruckten Schaltkreis durch leitfähige Spitzen sichergestellt wird.

4. Telephon nach einem der Ansprüche 1 bis 3, **dadurch gekennzeichnet, dass** der Schirm eine Beleuchtungsvorrichtung (211) aus einem elektrolumineszenten Film, dessen eine seiner Flächen metallisiert ist und die Rückseite des Schirms bildet, umfasst.

5. Telephon nach einem der Ansprüche 1 bis 4, **dadurch gekennzeichnet, dass** der Schirm einen Lichtleiter (311, 403) umfasst, wobei die Rückseite dieses Lichtleiters metallisiert ist, so dass sie einen Teil der Abschirmungsvorrichtung als Rückseite des Schirms bildet.

6. Telephon nach Anspruch 5, **dadurch gekennzeichnet, dass** der Lichtleiter ein Deckel (311, 403) ist, der die Abstrahlungskomponenten bedeckt, wobei der Deckel aus einem Material hergestellt ist, das Licht leitet, die Ränder des Deckels über eine leitfähige Verbindungsstelle mit dem gedruckten Schaltkreis in Kontakt stehen und die Innenfläche des Deckels metallisiert ist.

7. Telephon nach Anspruch 5 oder 6, **dadurch gekennzeichnet, dass** der Lichtleiter ein Deckel (311, 403) ist, der die Abstrahlungskomponenten bedeckt, wobei der Deckel aus einem Material hergestellt ist, das Licht leitet, die Ränder des Deckels über leitfähige Spitzen mit dem gedruckten Schaltkreis in Kontakt stehen und die Innenfläche des Deckels metallisiert ist.

8. Telephon nach einem der Ansprüche 5 bis 7, **dadurch gekennzeichnet, dass** der Lichtleiter auch als Lichtleiter für eine Telephontastatur (402) dient, wobei der Lichtleiter daher gegenüber der Tastatur selektive Metallisierungen oder Bahnen umfasst, um die elektrische Funktion der Tastatur sicherzustellen, und der Lichtleiter Wände umfasst, von denen einige metallisiert sind, um die Abschirmung der Abstrahlungskomponenten sicherzustellen.

9. Telephon nach Anspruch 8, **dadurch gekennzeichnet, dass** die Tastatur einen mehrschichtigen gedruckten Schaltkreis erfordert, wobei eine Schicht auf dem Lichtleiter angeordnet ist, die andere Schicht auf einer Blasenschicht (402) mit Tastaturtasten angeordnet ist und die Abschirmung zwischen der Blasenschicht und dem Lichtleiter daher mit einem Abschirmfilm bewirkt wird.

## Claims

1. Mobile telephone (100) comprising a screen (103) and electronic components (106) emitting electromagnetic radiation fixed to a printed circuit (107) and insulated by a screening device, **characterised in that** the screening device (105) is integrated in an element (103) of the screen in the form of metallisation (105) of the rear face of this element of the screen, the screening device is then constituted by the metallised rear face of the screen and a conducting frame (108) which provides the electrical connection between the metallised rear face and a ground of the printed circuit, the radiating components are then situated under the screen and inside the frame.

2. Telephone according to claim 1, **characterised in that** the electrical connection between the rear face of the screen and the frame, and the electrical connection between the frame and the printed circuit are provided by conducting joints (110, 109).

3. Telephone according to one of claims 1 or 2, **characterised in that** the electrical connection between the rear face of the screen and the frame, and the electrical connection between the frame and the printed circuit are provided by conducting pins.

4. Telephone according to one of claims 1 to 3, **characterised in that** the screen comprises a lighting device (211) constituted by an electroluminescent film one of the faces of which is metallised and serves as the rear face of the screen.

5. Telephone according to one of the claims 1 to 4, **characterised in that** the screen comprises a light guide (311, 403), the rear face of this light guide being metallised to form part of the screening device as the rear face of the screen.

6. Telephone according to claim 5, **characterised in that** the light guide is a cover (311, 403) covering the components emitting radiation, the cover is manufactured in a material conducting light, the edges of the cover are in contact with the printed circuit via a conducting joint, the internal face of the cover is metallised.

7. Telephone according to one of claims 5 or 6, **characterised in that** the light guide is a cover (311, 403) covering the components emitting radiation, the cover is manufactured in a material conducting light, the edges of the cover are in contact with the printed circuit via conducting pins, the internal face of the cover is metallised.

8. Telephone according to one of claims 5 to 7, **characterised in that** the light guide also serves as light guide for a keypad (402) of the telephone, the light guide then comprises selective metallisations, or tracks, opposite the keypad to ensure the electrical operation of the keypad, the light guide comprises walls some of which are metallised to provide the screening of the components emitting radiation.

9. Telephone according to claim 8, **characterised in that** the keypad requires a multi-layer printed circuit, one layer is formed on the light guide, the other layer is formed on a blister element (402) comprising keys of the keypad, the insulation between the blister element and the light guide then being formed by an insulating film.
